# DEMANDE DE BREVET EUROPEEN

(11) **EP 3 839 625 A1**
(43) Date de publication de la demande: **23.06.2021**
(21) Numéro de dépôt: 19217374.8
(22) Date de dépôt: 18.12.2019
(51) Int. Cl.: G03F 7/00, B81C 99/00, C25D 1/00, C25D 5/02

(54) **PROCEDE DE FABRICATION D'UN COMPOSANT HORLOGER ET COMPOSANT OBTENU SELON CE PROCEDE**

(71) Demandeur: Nivarox-FAR S.A., 2400 Le Locle (CH)
(72) Inventeur: CUSIN, Pierre, 1423 Villars-Burquin (CH); GANDELHMAN, Alex, 2013 Colombier (CH); MUSY, Michel, 2552 Orpund (CH); GOLFIER, Clare, 2520 La Neuveville (CH)
(74) Mandataire: ICB SA

(57) **Abrégé**

La présente invention concerne un procédé de fabrication de composant horloger métalliques caractérisé en ce qu'il comprend les étapes consistant à former par un procédé du type LIGA-UV un moule en résine photosensible multiniveau et à déposer galvaniquement une couche d'au moins un métal à partir d'une couche conductrice pour former un bloc atteignant sensiblement la surface supérieure de la résine photosensible.

## Description

### Domaine de l'invention

La présente invention concerne un procédé de fabrication d'une structure métallique complexe multi-niveaux au moyen de la technologie LIGA. L'invention concerne également une telle structure métallique, notamment des composants horlogers, obtenus par ce procédé.

### Arrière-plan de l'invention

On connaît déjà des procédés correspondant à la définition ci-dessus. En particulier, l'article d'A. B. Frazier et al. intitulé « Metallic Microstuctures Fabricated Using Photosensitive Polyimide Electroplating molds » et publié dans le journal of Microelectromechanical systems (Vol. 2, N deg. 2, June 1993) décrit un procédé pour la fabrication de structures métalliques multi-niveaux par croissance galvanique dans des moules de polyimide réalisés par photolithographie de couches de résine photosensible. Ce procédé comprend les étapes suivantes :
- créer sur un substrat une couche métallique sacrificielle et une couche d'amorçage pour une étape ultérieure de croissance galvanique,
- étaler une couche de polyimide photosensible,
- irradier la couche de polyimide avec un rayonnement UV à travers un masque correspondant au contour d'un niveau de la structure à obtenir,
- développer la couche de polyimide en dissolvant les parties non irradiées de façon à obtenir un moule en polyimide,
- remplir le moule de nickel jusqu'à la hauteur de celui-ci par croissance galvanique, et obtenir une surface supérieure sensiblement plane,
- déposer une fine couche de chrome sur toute la surface supérieure par vaporisation sous vide,
- déposer sur la couche de chrome une nouvelle couche de résine photosensible,
- irradier la couche de résine à travers un nouveau masque correspondant au contour du niveau suivant de la structure à obtenir,
- développer la couche de polyimide de façon à obtenir un nouveau moule,
- remplir le nouveau moule de nickel jusqu'à la hauteur de celui-ci par croissance galvanique.
- séparer la structure multi-niveaux et le moule en polyimide de la couche sacrificielle et du substrat,
- séparer la structure multi-niveaux du moule en polyimide.

On comprendra que le procédé qui vient d'être décrit peut, en principe, être mis en œuvre de manière itérative pour obtenir des structures métalliques ayant plus de deux niveaux.

Le document de brevet WO2010/020515A1 décrit la fabrication d'une pièce à plusieurs niveaux en réalisant un moule de photoresist complet correspondant à la pièce finale à obtenir avant l'étape de dépôt galvanique du métal de la pièce dans le moule. Seules des pièces multi-niveaux dont les projections des niveaux sont incluses l'une dans l'autre sont réalisables par cette méthode.

On connait également du document de brevet EP2405301A1, un moule en photoresist comprenant au moins deux niveaux, les niveaux formés dans le substrat ne comportant que des flancs verticaux et lisses.

Ces procédés ne permettent que la fabrication de pièces dont leurs géométries de base sont cylindriques, et ne permettent pas la fabrication de pièces comprenant des géométries complexes telles que des anglages ou des chanfreins.

### Résumé de l'invention

La présente invention a pour but de remédier aux inconvénients susmentionnés ainsi qu'à d'autres encore en fournissant un procédé permettant de fabriquer des composants horlogers métalliques multi-niveaux, en combinant une étape d'emboutissage à chaud à la technologie LIGA, dans lequel une couche conductrice est associée à une couche de résine pour chaque niveau pour permettre une croissance galvanique fiable dans le cas de composants multiniveaux.

La présente invention a également pour but de permettre la fabrication de pièces horlogères présentant des géométries complexes d'ordinaire infaisable via la technologie LIGA.

A cet effet l'invention a pour objet un procédé de fabrication d'au moins un composant horloger comprenant les étapes suivantes :
a) se munir d'un substrat et appliquer une première couche de résine photosensible ;
b) effectuer un emboutissage à chaud via un tampon de la première couche de résine, en pressant le tampon jusqu'à une distance prédéfinie du substrat de manière à conserver une couche de résine, pour mettre en forme la première couche de résine et définir un premier niveau du composant horloger ;
c) irradier la première couche de résine mise en forme pour définir au moins un premier niveau du composant ;
d) appliquer une deuxième couche de résine photosensible recouvrant la structure résultant de l'étape c), puis irradier la deuxième couche de résine à travers un masque définissant un deuxième niveau du composant et dissoudre les zones non irradiées de la deuxième couche de résine photosensible pour former un moule comprenant un premier et un second niveau ;
e) déposer une couche conductrice sur les surfaces de la première couche et de deuxième couche de résine ;
f) déposer une couche métallique par électroformage dans le moule à partir de la couche conductrice pour former le composant ;
g) éliminer successivement le substrat, la résine et la couche conductrice pour libérer le composant.

Ce procédé permet donc la réalisation de pièces multiniveaux sur un même wafer.

Conformément à d'autres variantes avantageuses de l'invention :
- l'étape b) est réalisée sous vide.
- lors de l'étape b), la première couche de résine est chauffée entre 70°C et 150°C.
- le tampon présente une empreinte en relief définissant ledit au moins premier niveau du composant ;
- la couche électriquement conductrice est mise en œuvre par dépôt global sur toutes les surfaces exposées ;
- la couche électriquement conductrice est déposée via un dépôt physique en phase vapeur, ou l'impression d'une encre ou d'une résine conductrice ;
- ladite couche électriquement conductrice est du type Au, Ti, Pt, Ag, Cr, Pd ou un empilement d'au moins deux de ces matériaux ;
- le substrat est en silicium ;
- le tampon est en matériau transparent de manière à irradier la première couche de résine au travers du tampon lorsque ce dernier est pressé contre le substrat ;
- la couche conductrice présente une épaisseur comprise entre 50nm et 500nm.

Enfin, l'invention se rapporte à un composant horloger, obtenu selon un procédé conforme à l'invention, tel qu'une ancre ou une roue d'échappement par exemple.

On comprend donc que le procédé de l'invention trouve une application particulièrement avantageuse pour la fabrication de composants pour les pièces d'horlogerie.

### Description sommaire des dessins

D'autres caractéristiques et avantages de la présente invention ressortiront plus clairement de la description détaillée qui suit d'un exemple de réalisation d'un procédé selon l'invention, cet exemple étant donné seulement à titre purement illustratif et non limitatif, en liaison avec le dessin annexé sur lequel :

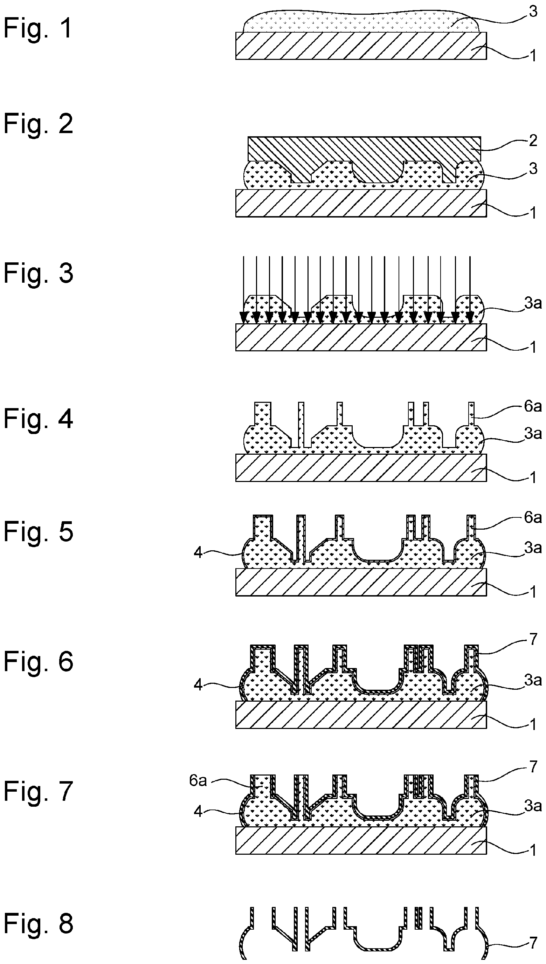

- les figures 1 à 8 illustrent les étapes de procédé d'un mode de réalisation de l'invention en vue de la réalisation d'un composant horloger.

### Description détaillée d'un mode de réalisation préféré

Le substrat 1 utilisé dans l'étape a) du procédé selon l'invention est, par exemple, formé par un substrat en silicium. Lors de la première étape a) du procédé on dépose une couche de résine photosensible sur le substrat. La résine photosensible 3 utilisée dans ce procédé est de préférence une résine de type négative à base d'époxy octofonctionnelle disponible sous la référence SU-8 conçue pour polymériser sous l'action d'un rayonnement UV.

Selon un mode de réalisation particulier de l'invention, la résine se présente sous la forme d'un film sec, la résine est alors appliquée par laminage sur le substrat 1.

Alternativement, la résine photosensible pourrait être un photorésist positif qui est conçu pour se décomposer sous l'action d'un rayonnement UV. On comprendra que la présente invention ne se limite pas à quelques types particuliers de résine photosensible. L'homme du métier saura choisir une résine photosensible convenant à ses besoins parmi toutes les résines connues qui sont adaptées à la photolithographie par UV.

La première couche de résine 3 est déposée sur le substrat 1 par tout moyen approprié, par enduction centrifuge, à la tournette, ou encore par sprayage jusqu'à l'épaisseur souhaitée. Typiquement l'épaisseur de résine est comprise entre 10 µm et 1000 µm, et de préférence entre 50 µm et 300 µm. Selon l'épaisseur désirée et la technique de dépôt utilisée la première couche de résine 3 sera déposée en une ou plusieurs fois.

La première couche de résine 3 est ensuite chauffée typiquement entre 90 et 120° C pendant une durée dépendant de l'épaisseur déposée pour évacuer le solvant (étape de pre-bake). Ce chauffage sèche et durcit la résine.

L'étape b) suivante illustrée à la figure 2 consiste à effectuer un emboutissage à chaud de la première couche de résine 3 pour la mettre en forme et définir un premier niveau du composant horloger. La résine est dans un premier temps chauffée à une température comprise entre 70°C et 150°C où elle devient visqueuse pour permettre sa mise en forme en l'écrasant au moyen d'un tampon 2 venant la presser. Cette étape est réalisée sous vide pour éviter la formation de bulles d'air lors du pressage de la couche de résine 3. Selon l'invention, le tampon 2 est pressé jusqu'à une distance prédéfinie du substrat 1 de manière à conserver une couche de résine sur le substrat 1.

Avantageusement, le tampon 2 présente une empreinte en relief pouvant présenter des variations de hauteur et permettant ainsi de définir au moins un premier niveau du composant, ledit au moins premier niveau présente ainsi une géométrie tridimensionnelle complexe qu'il n'est pas possible d'obtenir par un procédé LIGA classique.

Il peut également être envisagé de former deux niveaux ou plus au moyen du tampon pour réaliser la géométrie complète du composant à obtenir.

L'étape c) suivante illustrée à la figure 3 consiste à irradier la première couche de résine 3 au moyen d'un rayonnement UV pour définir le premier niveau du composant à former et ainsi former une unique zone photopolymérisée 3a.

Selon une alternative avantageuse, le tampon 2 est réalisé en un matériau transparent tel que du verre borosilicate. Un tel tampon 2 en matière transparente permet d'irradier la première couche de résine 3 directement au travers du tampon 2 lorsque ce dernier est pressé contre le substrat 1, au contact de la couche de résine, l'irradiation de la couche de résine pouvant se faire à chaud ou à température ambiante.

Une étape de recuit (étape de post-bake) de la première couche de résine 3 peut être nécessaire pour compléter la photopolymérisation induite par l'irradiation UV. Cette étape de recuit est effectuée de préférence entre 90°C et 95°C. La zone photopolymérisée 3a devient insensible à une grande majorité de solvants. Par contre, les zones non photopolymérisée peuvent ultérieurement être dissoutes par un solvant.

L'étape d) suivante illustrée à la figure 6 consiste à déposer une deuxième couche 6 de résine photosensible recouvrant la structure résultant de l'étape précédente c). La même résine est utilisée lors de cette étape, et l'épaisseur peut être supérieure à celle déposée lors de l'étape a). Généralement l'épaisseur varie en fonction de la géométrie du composant que l'on souhaite obtenir.

La suite consiste à irradier la deuxième couche 6 de résine à travers un masque définissant un deuxième niveau du composant et dissoudre les zones non irradiées de la deuxième couche 6 de résine photosensible. A la fin de cette étape (figure 6), on obtient un moule comprenant un premier et un second niveau formé par les zones photopolymérisée 3a et 6a.

La dissolution des zones non photopolymérisées est réalisée au moyen d'un solvant adéquat, tel que le PGMEA (propylène glycol méthyle éthyle acétate). Un moule en résine photosensible photopolymérisée 3a, 6a définissant un premier niveau et un deuxième niveau du composant est ainsi obtenu à la fin de l'étape 4.

L'étape e) consiste à déposer, par exemple, par un dépôt physique en phase vapeur (PVD), une couche conductrice 4, c'est-à-dire une couche apte à démarrer un dépôt métallique par voie galvanique. Typiquement, la couche conductrice 2 est du type Au, Ti, Pt, Ag, Cr ou Pd, ou un empilement d'au moins deux de ces matériaux, et présente une épaisseur comprise entre 50nm et 500nm. Par exemple, la couche conductrice 4 peut être formée d'une sous-couche de chrome ou de titane recouverte d'une couche d'or ou de cuivre. Selon l'invention, la couche électriquement conductrice 4 est mise en œuvre par dépôt global sur toutes les surfaces exposées, flancs compris.

L'homme du métier pourrait également envisager la mise en œuvre d'une impression 3D pour déposer la couche conductrice 4.

L'étape f) suivante illustrée à la figure 7 consiste à déposer dans le moule formé, par électroformage ou dépôt galvanique, une couche 7 d'un métal à partir de la couche 2 électriquement conductrice jusqu'à obtenir l'épaisseur souhaitée. Dans le cas où une faible épaisseur est requise, la croissance est relativement courte, ce qui permet d'obtenir des composants creux.

Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore, ou encore le nickel-tungstène. En général, la structure métallique multicouche est entièrement réalisée dans le même alliage ou métal. Toutefois, il est également possible de changer de métal ou d'alliage au cours de l'étape de déposition galvanique de manière à obtenir une structure métallique comportant au moins deux couches de natures différentes.

Les conditions d'électroformage, notamment la composition des bains, la géométrie du système, les tensions et densités de courant, sont choisis pour chaque métal ou alliage à électrodéposer selon les techniques bien connues dans l'art de l'électroformage.

L'étape g) consiste à usiner la couche métallique 7 par un procédé mécanique de manière à ajuster la hauteur du composant et séparer les différentes pièces si nécessaire (la croissance galvanique démarrant partout, toutes les pièces se trouvant sur un même support son liées les unes aux autres).

La dernière étape consiste à libérer le composant en éliminant par une succession d'étapes de gravure, humide ou sèche, le substrat, les couches conductrices ou les couches de résine, opérations familières à l'homme du métier. Par exemple la couche conductrice 2 et le substrat 1 sont éliminés au moyen d'une gravure humide, ce qui permet de libérer le composant du substrat 1 sans l'endommager. Notoirement, le substrat en silicium peut être gravé avec une solution à base d'hydroxyde de potassium (KOH).

A l'issue de cette première séquence, on obtient un composant pris dans les couches de résine. Une deuxième séquence consiste à éliminer la première couche 3 et la deuxième couche 6 de résine au moyen de gravures plasma O₂, espacées de gravures humides des couches métalliques intermédiaires.

A l'issue de cette étape, les composants obtenus peuvent être nettoyés, et éventuellement repris sur une machine-outil pour opérer des usinages ou une terminaison esthétique. A ce stade, les pièces peuvent être directement utilisées ou bien soumises à divers traitements décoratifs et/ou fonctionnels, typiquement des dépôts physiques ou chimiques.

Le procédé de l'invention trouve une application particulièrement avantageuse pour la fabrication de composants pour pièces d'horlogerie, tels que des ressorts, des ancres, des roues, des appliques, etc. Grâce à ce procédé, on peut réaliser des composants de forme plus diverses et présentant des géométries plus complexes que ceux obtenus via des opérations de photolithographie classiques. Un tel procédé permet également d'obtenir des composants de type « coque » relativement légers, robustes et qui présentent une bonne fiabilité au niveau des géométries.

## Revendications

1. Procédé de fabrication d'au moins un composant horloger comprenant les étapes suivantes :
a) se munir d'un substrat (1) et appliquer une première couche de résine photosensible (3) ;
b) effectuer un emboutissage à chaud via un tampon (2) de la première couche de résine (3), en pressant le tampon (2) jusqu'à une distance prédéfinie du substrat (1) de manière à conserver une couche de résine, pour mettre en forme la première couche de résine (3) ;
c) irradier la première couche de résine (3) mise en forme pour définir au moins un premier niveau du composant ;
d) appliquer une deuxième couche de résine photosensible (6) recouvrant la structure résultant de l'étape c), puis irradier la deuxième couche de résine (6) à travers un masque définissant un deuxième niveau du composant et dissoudre les zones non irradiées de la deuxième couche de résine photosensible (6) pour former un moule comprenant un premier et un second niveau ;
e) déposer une couche conductrice (4) sur les surfaces de la première couche et de deuxième couche de résine ;
f) déposer une couche métallique (7) par électroformage dans le moule à partir de la couche conductrice (4) pour former le composant ;
g) usiner la couche métallique (7) par un procédé mécanique de manière à ajuster la hauteur du composant, et libérer le composant.

2. Procédé selon la revendication 1, **caractérisé en ce que** l'étape b) est réalisée sous vide.

3. Procédé selon la revendication 1 ou 2, **caractérisé en ce que** lors de l'étape b), la première couche de résine est chauffée entre 70°C et 150°C.

4. Procédé selon l'une des revendications 1 à 3, **caractérisé en ce que** le tampon présente une empreinte en relief pour définir ledit au moins premier niveau du composant.

5. Procédé selon l'une des revendications 1 à 4, **caractérisé en ce que** lors de l'étape e), la couche électriquement conductrice (4) est mise en œuvre par dépôt global sur toutes les surfaces exposées.

6. Procédé selon l'une des revendications 1 à 5, **caractérisé en ce que** lors de l'étape d), la couche électriquement conductrice (4) est déposée via un dépôt physique en phase vapeur, l'impression d'une encre ou une résine conductrice.

7. Procédé selon l'une des revendications précédentes, **caractérisé en ce que** ladite couche électriquement conductrice (4) est du type Au, Ti, Pt, Ag, Cr, Pd.

8. Procédé selon l'une des revendications précédentes, **caractérisé en ce que** le substrat (1) est en silicium.

9. Procédé selon l'une des revendications 1 à 7, **caractérisé en ce que** le tampon (2) est en matériau transparent de manière à irradier la première couche de résine (3) au travers du tampon (2) lorsque ce dernier est pressé contre le substrat (1).

10. Procédé selon l'une des revendications précédentes, **caractérisé en ce que** la couche conductrice (4) présente une épaisseur comprise entre 50nm et 500nm.

11. Composant horloger obtenu selon un procédé conforme à l'une des revendications 1 à 10.
